(19) Europäisches Patentamt
European Patent Office
Office européen des brevets

(11) **EP 4 443 742 A1**

(12) **EUROPEAN PATENT APPLICATION**
published in accordance with Art. 153(4) EPC

(43) Date of publication:
**09.10.2024 Bulletin 2024/41**

(21) Application number: **22898360.7**

(22) Date of filing: **01.11.2022**

(51) International Patent Classification (IPC):
**H02S 40/20** (2014.01)    **H01L 31/042** (2014.01)

(52) Cooperative Patent Classification (CPC):
**H01L 31/042; H02S 40/20**

(86) International application number:
**PCT/JP2022/040924**

(87) International publication number:
**WO 2023/095575 (01.06.2023 Gazette 2023/22)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.11.2021 JP 2021193668**

(71) Applicant: **Zeon Corporation**
**Tokyo 100-8246 (JP)**

(72) Inventors:
• **YOSHIDA, Masayoshi**
**Tokyo 100-8246 (JP)**
• **MATSUO, Takatoshi**
**Tokyo 100-8246 (JP)**

(74) Representative: **Maiwald GmbH**
**Elisenhof**
**Elisenstraße 3**
**80335 München (DE)**

(54) **SOLAR BATTERY MODULE**

(57)    A solar cell module having a design region corresponding to a power-generating cell, wherein the design region consists of one unit region or a repeat of two or more unit regions, the unit region consists of a plurality of partial regions having different average transmittances throughout the entire design region, and the average transmittance throughout the entire design region and the area fraction in the unit region, of each of the partial regions are set to satisfy Formula 1 in which the average transmittance of the design region is not less than an arbitrary constant:
[Math. 1]

$$T_d = \sum_{m=1}^{n} \left( T_{a\_m} \cdot R_{p\_m} \right) \geq C$$

... Formula 1

wherein Td is an average transmittance of the design region, n is the number of partial regions that constitute the unit region, Ta_m is an average transmittance throughout the entire design region in the m-th partial region ($0 \leq T_{a\_m} \leq 1$), Rp_m is an area fraction in the unit region of the m-th partial region ($0 < R_{p\_m} < 1$), and C is an arbitrary constant ($0 \leq C \leq 1$).

FIG. 1

**Description**

TECHNICAL FIELD

This disclosure relates to a solar cell module.

BACKGROUND

It is known a solar cell module in which printing is applied to the light-receiving surface side with respect to the solar cell module body (see, for example, JP2017-216766A (PTL 1)).

CITATION LIST

Patent Literature

PTL 1: JP2017-216766A

SUMMARY

(Technical Problem)

Excellent designability and power generating performance are required for solar cell modules as described above.
It could be helpful to provide a solar cell module that is likely to achieve excellent designability and power generating performance.

(Solution to Problem)

A solar cell module according to one of the disclosed aspects is a solar cell module having a design region corresponding to a power-generating cell, wherein the design region consists of one unit region or a repeat of two or more unit regions, the unit region consists of a plurality of partial regions having different average transmittances throughout the entire design region, and the average transmittance throughout the entire design region and the area fraction in the unit region, of each of the partial regions are set to satisfy Formula 1 in which the average transmittance of the design region is not less than an arbitrary constant:

[Math. 1]

$$T_d = \sum_{m=1}^{n} \left( T_{a\_m} \cdot R_{p\_m} \right) \geq C$$

$$\dots \text{ Formula } 1$$

wherein Td is an average transmittance of the design region,

n is the number of partial regions that constitute the unit region,
Ta_m is an average transmittance throughout the entire design region in the m-th partial region ($0 \leq$ Ta_m $\leq 1$),
Rp_m is an area fraction in the unit region of the m-th partial region ($0 <$ Rp_m $< 1$), and
C is an arbitrary constant ($0 \leq$ C $\leq 1$).

With such configuration, appropriately setting the value of the constant C can balance the visibility of a design expressed on the entire design region and the amount of light passing through the design to contribute to power generation, resulting in easy achievement of excellent designability and power generating performance.
A solar cell module according to one of the disclosed embodiments is a solar cell module, wherein the solar cell module has a background region between the design region and the power-generating cell, and the average transmittance of the background region, and the average transmittance throughout the entire design region and the area fraction in the unit region, of each of the partial regions are set to satisfy Formula 2 in which a value obtained by multiplying the average transmittance of the design region by the average transmittance of the background region is not less than the constant:
[Math. 2]

$$T_b \cdot \sum_{m=1}^{n} \left( T_{a\_m} \cdot R_{p\_m} \right) \geq C$$

… Formula 2

wherein Tb is an average transmittance of the background region.

With such configuration, considering the transmittance of the background region, excellent designability and power generating performance can be more easily achieved.

A solar cell module according to one of the embodiments is a solar cell module, wherein the constant is set so that the average transmittance of the entire power-generating cell is 0.5 or more. With such configuration, excellent designability and power generating performance can be more easily achieved.

A solar cell module according to one of the embodiments is a solar cell module, wherein the area fraction of the design region in the power-generating cell is 0.5 or more and 1 or less, and the constant is set to satisfy Formula 3:
[Math. 3]

$$C = 1 - \frac{1}{2R_d}$$

… Formula 3

wherein Rd is an area fraction of the design region in the power-generating cell ($0.5 \leq Rd \leq 1$).

With such configuration, considering the area fraction of the design region in the power-generating cell, excellent designability and power generating performance can be more easily achieved.

A solar cell module according to one of the embodiments is a solar cell module, wherein the background region is white. With such configuration, the visibility of the design region can be easily increased.

A solar cell module according to one of the embodiments is a solar cell module, wherein the average transmittance throughout the entire design region in each of the partial regions is adjusted by ink concentration. With such configuration, the transmittance of the entire design region can be easily adjusted.

A solar cell module according to one of the embodiments is a solar cell module, wherein the average transmittance throughout the entire design region in one of the plurality of partial regions is 1. With such configuration, by setting the average transmittance throughout the entire design region in one partial region to 1, the average transmittance throughout the entire design region in the other partial regions can be decreased, and the visibility of the design region can be easily increased while keeping the power generating performance.

A solar cell module according to one of the embodiments is a solar cell module, wherein the unit region is a square. With such configuration, the visibility of the design region can be easily increased.

A solar cell module according to one of the embodiments is a solar cell module, wherein the unit region consists of a plurality of minimum unit regions that are each a square, regular polygon, or circle, and each of the partial regions consists of one or more of the minimum unit regions. With such configuration, the visibility of the design region can be easily increased.

A solar cell module according to one of the embodiments is a solar cell module, wherein the unit region and the minimum unit region are each a square, and at least one of the partial regions in the unit region is continuously arranged in none of the vertical and horizontal directions along the sides of the square. With such configuration, the visibility of the design region can be easily increased.

A solar cell module according to one of the embodiments is a solar cell module, wherein the unit region and the minimum unit region are each a square, and at least one of the partial regions in the unit region is continuously arranged in any of the vertical and horizontal directions along the sides of the square. With such configuration, the visibility of the design region can be easily increased.

A solar cell module according to one of the embodiments is a solar cell module, wherein the design region is encompassed by a region over the power-generating cell or encompassed by a region including the region over the power-generating cell and an extended region extended by a predetermined width from the end edge of the power-generating cell. With such configuration, the design region can be caused to appropriately correspond to the power-generating cell, and as a result, excellent designability and power generating performance can be more easily achieved.

A solar cell module according to one of the embodiments is a solar cell module, wherein the design region has an uneven thickness. With such configuration, excellent designability and power generating performance when using stereoscopic printing by a 3D printer or the like can be easily achieved.

A solar cell module according to one of the embodiments is a solar cell module, wherein the solar cell module has an upper layer region that displays a label consisting of a character, number, or symbol, on the design region. With such configuration, excellent designability and power generating performance when having an upper layer region can be easily achieved.

A solar cell module according to one of the embodiments is a solar cell module, wherein one of the contour and its inside region of the label is white, and the other is black. With such configuration, the visibility of the upper layer region can be easily increased.

A solar cell module according to one of the embodiments is a solar cell module, wherein the average transmittance throughout the entire design region in each of the partial regions is (i) a ratio of the short circuit current of the solar cell module when the partial regions are provided over the entire surface of the power-generating cell, with respect to the short circuit current of the solar cell module without the design region, when the power-generating cell is irradiated with sunlight of 1 SUN, or (ii) a ratio of the power generation current at a predetermined operating point voltage of the solar cell module when the partial regions are provided over the entire surface of the power-generating cell, with respect to the power generation current at the predetermined operating point voltage of the solar cell module without the design region, when the power-generating cell is irradiated with sunlight of 1 SUN. With such configuration, excellent designability and power generating performance can be more easily achieved.

A solar cell module according to one of the embodiments is a solar cell module, wherein the solar cell module has a plurality of the power-generating cells and a plurality of the design regions corresponding to the plurality of the power-generating cells. With such configuration, the power generating performance can be easily increased.

A solar cell module according to one of the embodiments is a solar cell module, wherein the solar cell module has a further design region that does not correspond to the plurality of the power-generating cells, and the further design region has an average transmittance smaller than the constant. With such configuration, the designability can be easily increased.

A print data generation device according to one of the aspects is a print data generation device for the solar cell module, wherein, as print data to be printed on a predetermined region consisting of any of the partial regions of the entire design region, a part corresponding to the predetermined region is extractable from a predetermined image. With such configuration, a solar cell module that is likely to achieve excellent designability and power generating performance can be easily provided.

A print data generation device according to one of the embodiments is a print data generation device, wherein the average transmittance throughout the entire design region and the area fraction in the unit region, of each of the partial regions are set so that the average transmittance of the design region is not less than the constant. With such configuration, a solar cell module that is likely to achieve excellent designability and power generating performance can be more easily provided.

A printer according to one of the aspects is a printer configured to apply printing on the solar cell module based on print data generated by the print data generation device. With such configuration, a solar cell module that is likely to achieve excellent designability and power generating performance can be easily provided.

(Advantageous Effect)

According to this disclosure, a solar cell module that is likely to achieve excellent designability and power generating performance can be provided.

BRIEF DESCRIPTION OF THE DRAWINGS

In the accompanying drawings:

FIG. 1 is a conceptual diagram that illustrates a design region of a solar cell module according to one of the disclosed embodiments;
FIG. 2 is a conceptual diagram that illustrates an arrangement of a background region of a solar cell module according to one of the embodiments;
FIG. 3 is a conceptual diagram that illustrates a design region of a solar cell module according to one of the embodiments;
FIG. 4 is a conceptual diagram that illustrates a layer composition of a solar cell module according to one of the embodiments;
FIG. 5 is an explanatory diagram that illustrates an experimental example when the design region is formed with different ink concentrations;

FIGS. 6A to 6C are each an explanatory diagram that illustrates an example of a configuration in which the average transmittance throughout the entire design region in one of a plurality of partial regions is 1;

FIGS. 7A to 7E are each an explanatory diagram that illustrates one example of a unit region;

FIGS. 8A to 8E are each an explanatory diagram that illustrates one example of the unit region;

FIGS. 9A to 9C are each an explanatory diagram that illustrates one example of the unit region;

FIGS. 10A to 10C are each an explanatory diagram that illustrates one example of the unit region;

FIGS. 11A and 11B are each an explanatory diagram that illustrates one example of correspondence of the design region with respect to a power-generating cell;

FIG. 12 is an explanatory diagram that illustrates one example in a case where a design layer is formed by stacking a plurality of print layers formed by 2D printing;

FIG. 13 is an explanatory diagram that illustrates one example in a case where a design layer is formed by a 3D printer;

FIG. 14 is an explanatory diagram that illustrates one example in a case where the design region has an uneven thickness;

FIGS. 15A and 15 B are each an explanatory diagram that illustrates one example of a label;

FIG. 16 is a graph that illustrates one example of current-voltage characteristics of a solar cell module;

FIG. 17 is a conceptual diagram that illustrates one example of the production process of a solar cell module according to one of the embodiments;

FIG. 18 is a conceptual diagram that illustrates one example of the production process of a solar cell module according to one of the embodiments;

FIGS. 19A to 19C are each a graph that illustrates one example of the relationship between the ink concentration and transmittance;

FIG. 20 is a graph that illustrates one example of the relationship between the area fraction in the unit region of a white first partial region and the average transmittance of the design region;

FIGS. 21A to 21C are each an explanatory diagram that illustrates one example of a configuration in which the design layer is provided corresponding to a part of the power-generating cell;

FIGS. 22A to 22C are each an explanatory diagram that illustrates one example of a configuration in which a predetermined image is provided according to a predetermined pattern on only a partial region of the design layer;

FIG. 23 is a photograph of a solar cell module produced as Example 1; and

FIG. 24 is a photograph of a solar cell module produced as Example 2.

DETAILED DESCRIPTION

Embodiments of this disclosure will be described with reference to the drawings.

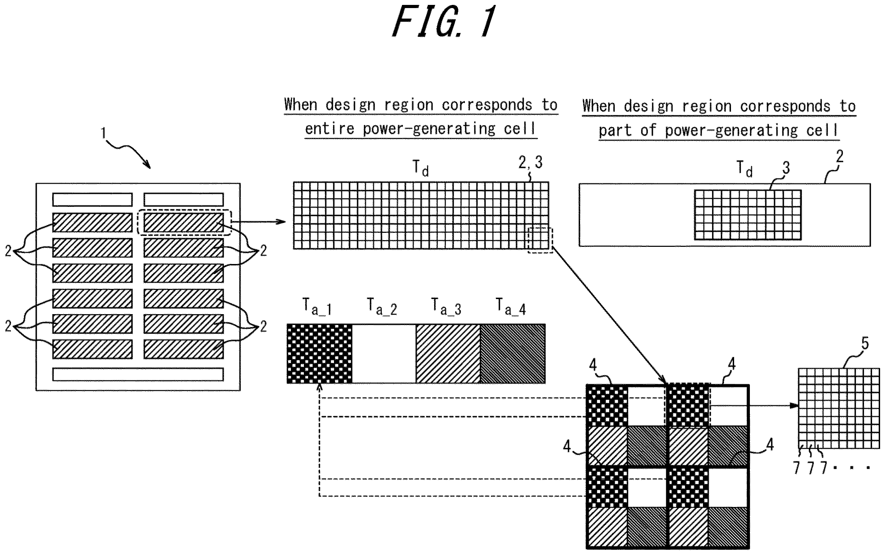

As illustrated in FIG. 1, in one of the embodiments, a solar cell module 1 has a design region 3 corresponding to a power-generating cell 2, the design region 3 consists of one unit region 4 or a repeat of two or more unit regions 4, the unit region 4 consists of a plurality of partial regions 5 having different average transmittances throughout the entire design region 3, and the average transmittance throughout the entire design region 3 and the area fraction in the unit region 4, of each of the partial regions 5 are set to satisfy Formula 1 below in which an average transmittance Td of the design region 3 is not less than an arbitrary constant C:

[Math. 4]

$$T_d = \sum_{m=1}^{n} \left( T_{a\_m} \cdot R_{p\_m} \right) \geq C$$

$$\ldots \text{Formula } 1$$

wherein Td is an average transmittance of the design region 3,

n is the number of the partial regions 5 that constitute the unit region 4,

$T_{a\_m}$ is an average transmittance throughout the entire design region 3 in the m-th partial region ($0 \leq T_{a\_m} \leq 1$),

$R_{p\_m}$ is an area fraction in the unit region 4 of the m-th partial region ($0 < R_{p\_m} < 1$), and

C is an arbitrary constant ($0 \leq C \leq 1$).

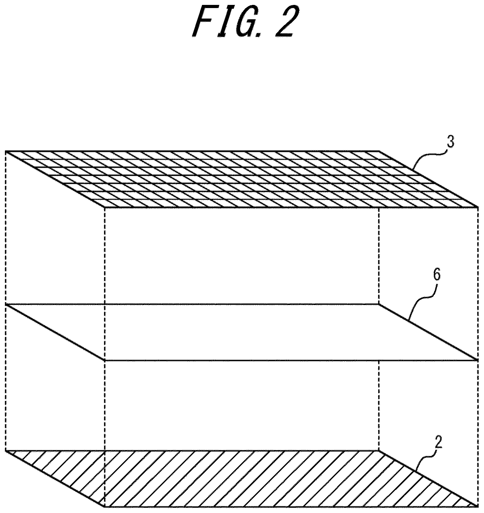

The solar cell module 1 has a background region 6 (see FIG. 2) between the design region 3 and the power-generating cell 2 and may be configured such that an average transmittance Tb of the background region 6, and the average transmittance throughout the entire design region 3 and the area fraction in the unit region 4, of each of the partial regions 5 are set to satisfy Formula 2 below in which a value obtained by multiplying the average transmittance Td of the design region 3 by the average transmittance Tb of the background region 6 is not less than the constant C:
[Math. 5]

$$T_b \cdot \sum_{m=1}^{n} \left( T_{a\_m} \cdot R_{p\_m} \right) \geq C$$

$$\dots \text{ Formula 2}$$

wherein Tb is an average transmittance of the background region 6.

The solar cell module 1 may be configured such that the constant C is set so that an average transmittance Ts of the entire power-generating cell 2 is 0.5 or more.

The solar cell module 1 may be configured such that an area fraction Rd of the design region 3 in the power-generating cell 2 is 0.5 or more and 1 or less, and the constant C is set to satisfy Formula 3 below:
[Math. 6]

$$C = 1 - \frac{1}{2R_d}$$

$$\dots \text{ Formula 3}$$

wherein Rd is an area fraction of the design region 3 in the power-generating cell 2 ($0.5 \leq Rd \leq 1$).

When the design region 3 corresponds to the entire power-generating cell 2, a power generation amount P of the power-generating cell 2 is expressed by the formula below:

$$\text{P} = \text{a} \bullet \text{E} \bullet \text{S} \bullet \text{Td}$$
$$= \text{a} \bullet \text{E} \bullet (\text{Ta\_1} \bullet \text{Sa\_1} + \text{Ta\_2} \bullet \text{Sa\_2} + \dots + \text{Ta\_k} \bullet \text{Sa\_k})$$

wherein a is a constant of proportionality,

E is a light energy per unit area,
S is an area of the design region 3, and
Sa_k is an area of an aggregate throughout the entire design region 3 in the k-th partial region.

The design region 3 is an aggregate of N pieces of the unit regions 4, and thus:

$$\text{P} = \text{a} \bullet \text{E} \bullet (\text{Ta\_1} \bullet \text{N} \bullet \text{Sp\_1} + \text{Ta\_2} \bullet \text{N} \bullet \text{Sp\_2} + \dots + \text{Ta\_k} \bullet \text{N} \bullet \text{Sp\_k})$$
$$= \quad \text{a} \bullet \text{E} \bullet \{ \text{Ta\_1} \bullet \text{N} \bullet (\text{Rp\_1} \bullet \text{Su}) \quad + \quad \text{Ta\_2} \bullet \text{N} \bullet (\text{Rp\_2} \bullet \text{Su}) \quad + \quad \dots \quad +$$
$$\text{Ta\_k} \bullet \text{N} \bullet (\text{Rp\_k} \bullet \text{Su}) \}$$
$$= \text{a} \bullet \text{E} \bullet \{ \text{N} \bullet \text{Su} \bullet (\text{Ta\_1} \bullet \text{Rp\_1} + \text{Ta\_2} \bullet \text{Rp\_2} + \dots + \text{Ta\_k} \bullet \text{Rp\_k}) \}$$
$$= \text{a} \bullet \text{E} \bullet \text{S} \bullet (\text{Ta\_1} \bullet \text{Rp\_1} + \text{Ta\_2} \bullet \text{Rp\_2} + \dots + \text{Ta\_k} \bullet \text{Rp\_k})$$

wherein Sp_k is an area of the k-th partial region,

Rp_k is an area fraction in the unit region 4 of the k-th partial region, and
Su is an area of the unit region 4.

When this is compared with P = a•E•S•Td, which is a formula before deformation, it is found that:

$$\text{Td} = \text{Ta\_1} \bullet \text{Rp\_1} + \text{Ta\_2} \bullet \text{Rp\_2} + \dots + \text{Ta\_k} \bullet \text{Rp\_k} \dots \text{ Formula 4}.$$

This is equivalent to a formula that expresses Td in Formula 1.

When the number of the partial regions 5 is 2 in Formula 4:

$$Td = Ta\_1 \bullet Rp\_1 + Ta\_2 \bullet Rp\_2$$
$$= Ta\_1 \bullet Sa\_1/S + Ta\_2 \bullet Sa\_2/S$$
$$= Ta\_1 \bullet (S - Sa\_2)/S + Ta\_2 \bullet Sa\_2/S$$
$$= Ta\_1 - Ta\_1 \bullet Sa\_2/S + Ta\_2 \bullet Sa\_2/S$$
$$= Ta\_1 + Sa\_2/S \bullet (Ta\_2 - Ta\_1).$$

Here, when the design region 3 consists of one unit region 4, an average transmittance Ta_1 throughout the entire design region 3 in a first partial region 5a is 1, and an area fraction Rp_2 in the unit region 4 of a second partial region 5b is 0.5 or more and 1 or less,

$$Td = 1 + Rp\_2(Ta\_2 - 1).$$

Therefore, in a case of Td = C = 0.5,
from 0.5 = 1 + Rp_2(Ta_2-1),

$$Ta\_2 = 1 - \{1/(2Rp\_2)\}.$$

In this case, if it is though that the second partial region 5b corresponds to the design region 3 when the area fraction Rd of the design region 3 in the power-generating cell 2 is 0.5 or more and 1 or less, Ta_2 = Td = C and Rp_2 = Rd. Therefore, Ta_2 = 1 - {1/(2Rp_2)} above is equivalent to Formula 3.

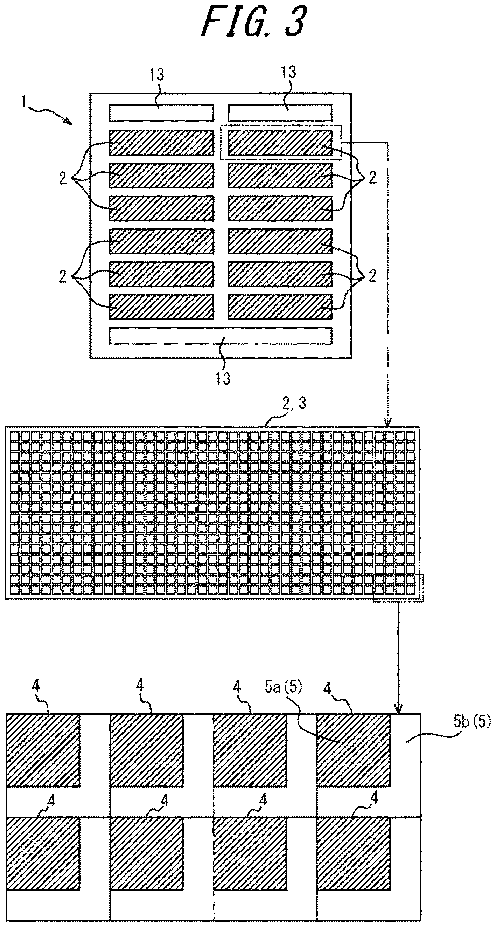

FIG. 1 illustrates an example when the unit region 4 consists of four partial regions 5. However, the number of the partial regions 5 that constitute the unit region 4 is not limited to four and may be two or more. For example, as illustrated in FIG. 3, the unit region 4 may consist of two partial regions 5. In the example illustrated in FIG. 3, each unit region 4 has two partial regions 5 consisting of the first partial region 5a and the second partial region 5b. In FIG. 3, the reference signs regarding the partial regions 5 are illustrated for only one unit region 4. The number of the unit regions 4 that constitute the design region 3 may be set as appropriate.

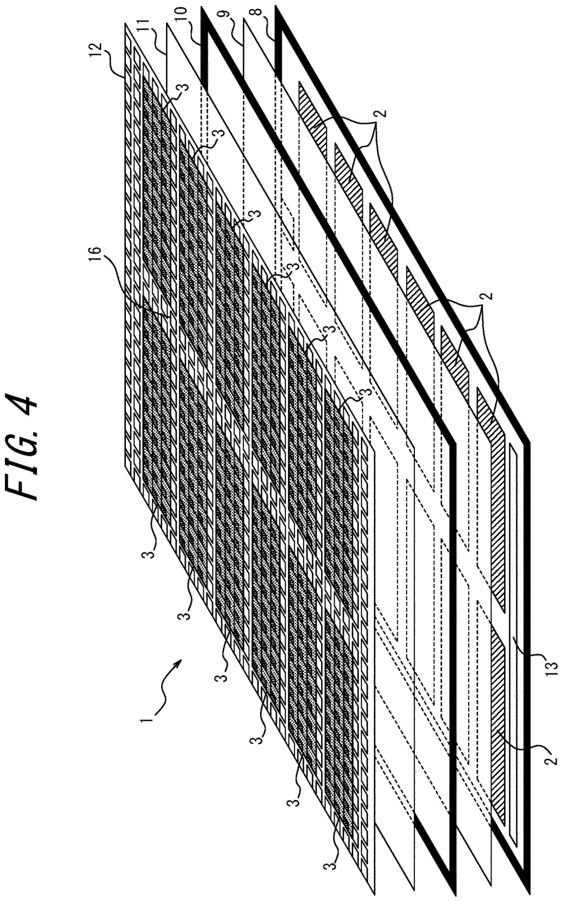

The solar cell module 1 may be configured to have a solar cell module body 8, an adhesive layer 9, a transparent film 10, a background layer 11, and a design layer 12 toward the light-receiving surface side, as illustrated in FIG. 4. In this case, the design region 3 is provided by the design layer 12, and the background region 6 is provided by the background layer 11. The solar cell module 1 has one or more power-generating cells 2. When the solar cell module 1 has a plurality of power-generating cells 2, the power-generating cells 2 are mutually connected in series or in parallel. A current-collecting electrode 13 connected to the power-generating cell 2 may be provided as appropriate.

The solar cell module body 8 may be configured from a dye-sensitized solar cell. That is, the solar cell module body 8 may be configured from a dye-sensitized power-generating cell. The solar cell, which is a photoelectric conversion element that converts light energy into electricity, includes a silicon solar cell or the like, in addition to the dye-sensitized solar cell. However, the dye-sensitized solar cell particularly has advantages such that it is advantageous in weight saving, has a wide illumination range to ensure stable power generation, reduces the scale of production equipment, and can be produced with cheap materials. The solar cell module body 8 may be configured from a solar cell such as a silicon solar cell other than the dye-sensitized solar cell.

The solar cell module 1 may be configured such that the back surface side can be seen through from the light-receiving surface side at least at a part of the design region 3. Here, the phrase "can be seen through" means that at least one element of shape, pattern, and color, which are elements that constitute the form of the background positioned at the opposite side of the solar cell module 1, can be visually recognized. The materials of the solar cell module body 8, the adhesive layer 9, the transparent film 10, the background layer 11, and the design layer 12 for configuring the solar cell module 1 to be able to be seen through are not particularly limited, and these components may be configured form known materials.

The solar cell module 1 may be configured such that the background region 6 is white.

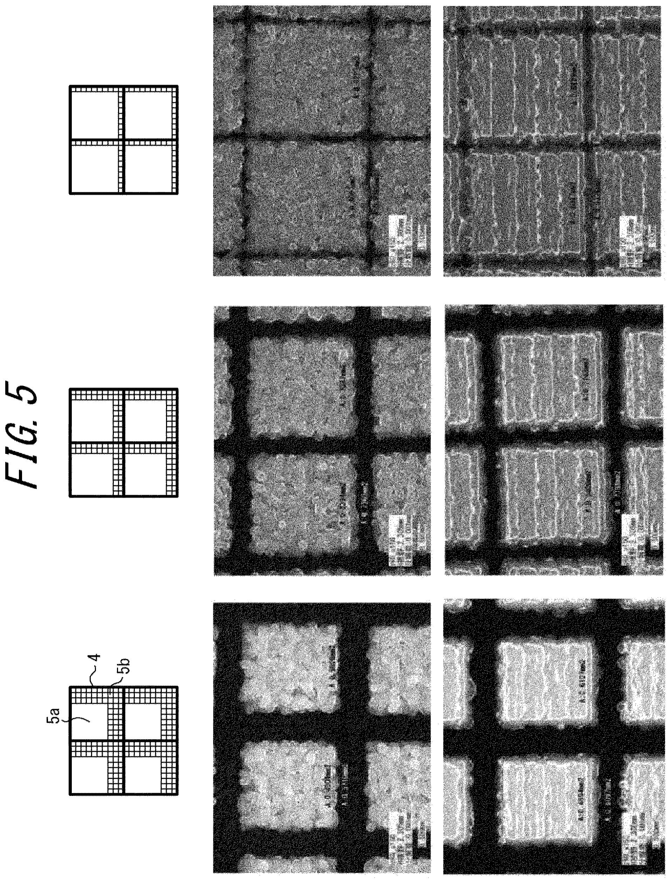

The solar cell module 1 may be configured such that the average transmittance throughout the entire design region 3 in each of the partial regions 5 is adjusted by ink concentration. FIG. 5 illustrates an experimental example when the design region 3 is formed with different ink concentrations. FIG. 5 illustrates photographic images of the design region 3, in which the first partial region 5a is printed with white ink, there is no print in the second partial region 5b, the left column illustrates a case where the area fraction Rp_1 in the unit region 4 of the first partial region 5a is 0.49, the middle column illustrates a case where the area fraction Rp_1 in the unit region 4 of the first partial region 5a is 0.64, the right column illustrates a case where the area fraction Rp_1 in the unit region 4 of the first partial region 5a is 0.81, the upper line illustrates a case where the ink concentration is 20%, and the lower line illustrates a case where the ink concentration is 100%.

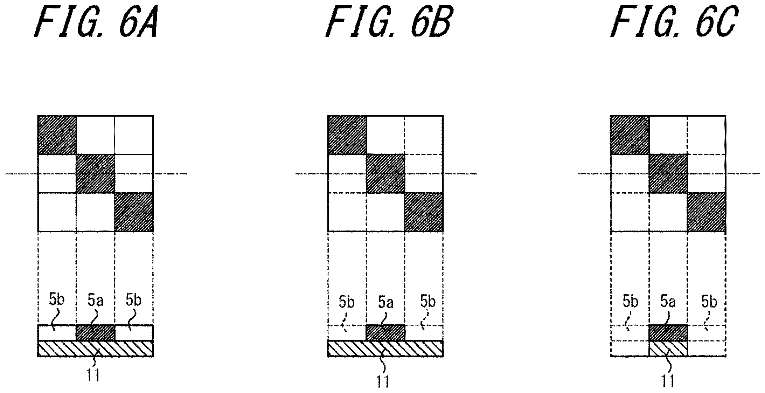

The solar cell module 1 may be configured such that the average transmittance throughout the entire design region 3 in one of the plurality of partial regions 5 is 1. FIGS. 6A to 6C each illustrate one example of this case. FIGS. 6A to 6C each illustrate a top view of the unit region 4 from the light-receiving surface side in the upper line, and a cross-sectional view at the dashed-dotted line in the top view in the lower line. FIGS. 6A to 6C each illustrate a configuration in which the average transmittance throughout the entire design region 3 in the second partial region 5b is 1. FIG. 6A illustrates an example in which the second partial region 5b is configured by the transparent part of the design layer 12 and the background layer 11 is provided over the entire unit region 4. FIG. 6B illustrates an example in which the second partial region 5b is configured by the intermittent part of the design layer 12 and the background layer 11 is provided over the entire unit region 4. FIG. 6C illustrates an example in which the second partial region 5b is configured by the intermittent part of the design layer 12 and the background layer 11 is equipped with an intermittent part corresponding to the second partial region 5b.

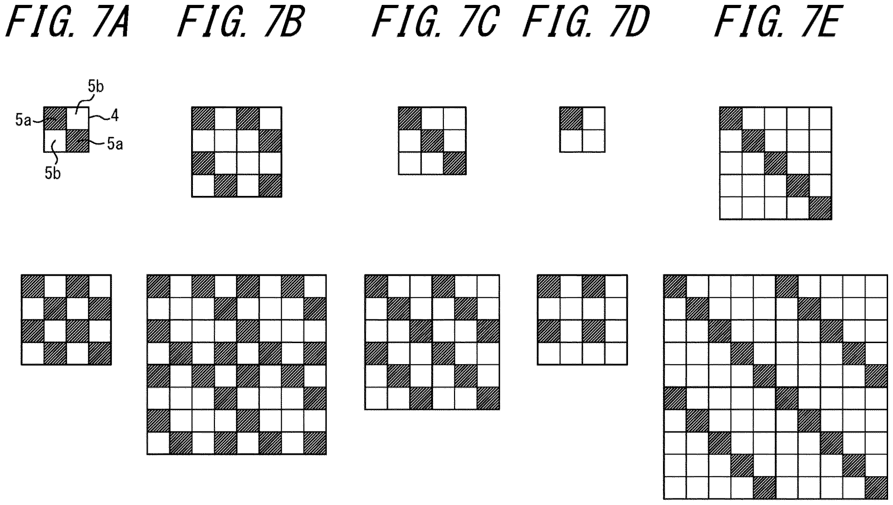

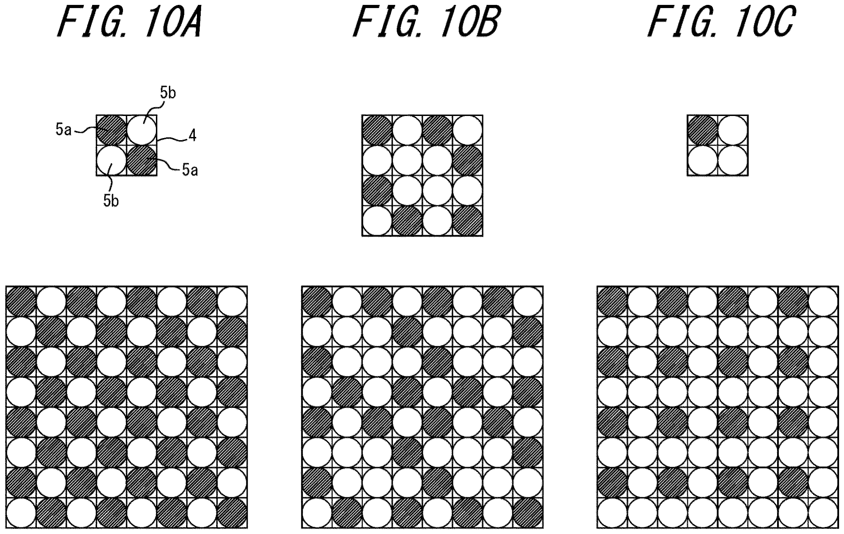

When the average transmittance throughout the entire design region 3 and the area fraction in the unit region 4, of each of the partial regions 5 are set, the area of the unit region 4 may be changed depending on the average transmittance throughout the entire design region 3 or the area fraction in the unit region 4, of each of the partial regions 5. FIG. 7A to FIG. 10C each illustrate one example of this case. The examples in FIG. 7A to FIG. 10C are different in the form of the unit region 4 but common in that the area of the unit region 4 changes as the area fraction Rp_1 in the unit region 4 of the first partial region 5a increases. In FIG. 7A to FIG. 10C, as changed from A to B, C ..., the area fraction Rp_1 in the unit region 4 of the first partial region 5a decreases. In FIG. 7A to FIG. 10C, the upper line illustrates the unit region 4, and the lower line illustrates a region in which the unit regions 4 are vertically and horizontally continuous.

The solar cell module 1 may be configured such that the unit region 4 is a square (see, for example, FIG. 7A to FIG. 9C).

The solar cell module 1 may be configured such that the unit region 4 consists of a plurality of minimum unit regions 7 that are each a square, regular polygon, or circle, and each of the partial regions 5 consists of one or more minimum unit regions 7 (see, for example, FIG. 7A to FIG. 10C).

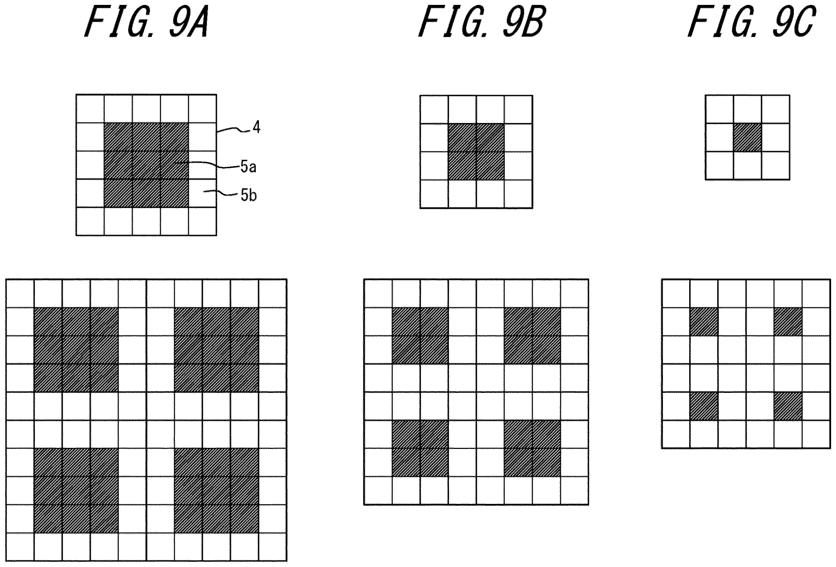

The solar cell module 1 may be configured such that the unit region 4 and the minimum unit region 7 are each a square, and at least one partial region 5 in the unit region 4 is continuously arranged in none of the vertical and horizontal directions along the sides of the above square. In this case, for example, as illustrated in FIGS. 7A to 7E, the solar cell module 1 may be configured such that the first partial region 5a is continuously arranged in none of the vertical and horizontal directions along the sides of the above square, or, for example, as illustrated in FIGS. 9A to 9C, the solar cell module 1 may be configured such that the first partial region 5a is continuously arranged in none of the vertical and horizontal directions along the sides of the above square.

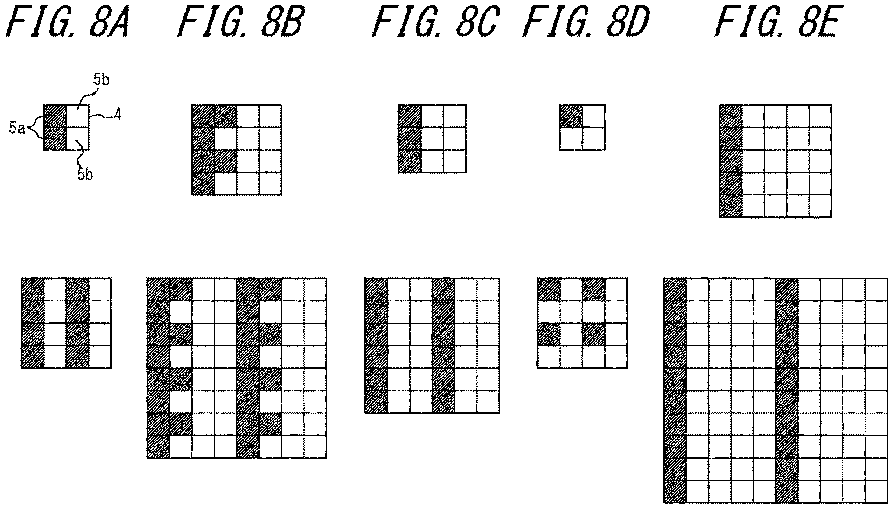

The solar cell module 1 may be configured such that the unit region 4 and the minimum unit region 7 are each a square, and at least one partial region 5 in the unit region 4 is continuously arranged in any of the vertical and horizontal directions along the sides of the above square. In this case, for example, as illustrated in FIGS. 7A to 7E, the solar cell module 1 may be configured such that the second partial region 5b is continuously arranged in any of the vertical and horizontal directions along the sides of the above square, for example, as illustrated in FIGS. 8A to 8E, the solar cell module 1 may be configured such that the second partial region 5b is continuously arranged in any of the vertical and horizontal directions along the sides of the above square, or, for example, as illustrated in FIGS. 9A to 9C, the solar cell module 1 may be configured such that the second partial region 5b is continuously arranged in any of the vertical and horizontal directions along the sides of the above square.

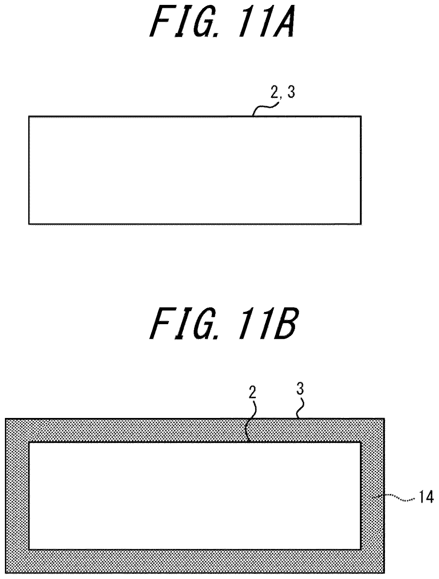

The solar cell module 1 may be configured such that the design region 3 is encompassed by a region over the power-generating cell 2 (see, for example, FIG. 11A) or encompassed by a region including the region over the power-generating cell 2 and an extended region 14 extended by a predetermined width from the end edge of the power-generating cell 2 (see, for example, FIG. 11B). Adding the extended region 14 allows a design that also considers the transmittance with respect to the light incident from the direction that is not perpendicular to and is inclined from the light-receiving surface of the solar cell module 1. It is preferable that the width of the extended region 14 is set greater as the thickness of the design layer 12 increases.

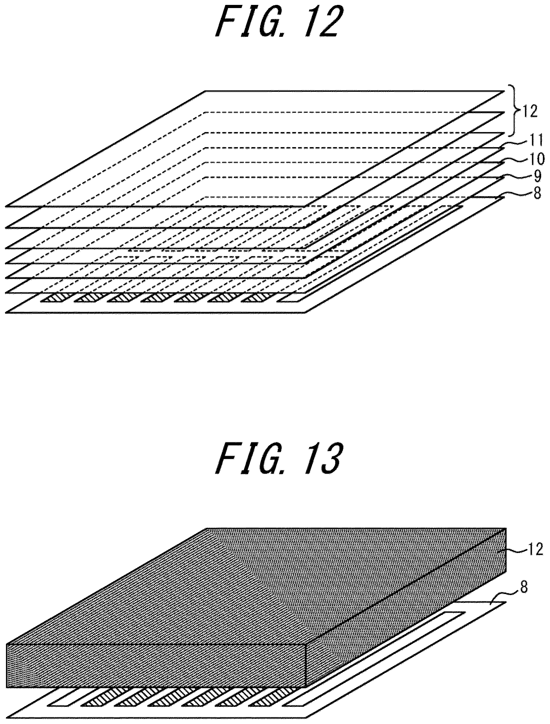

The design layer 12 may be formed by 3D modeling. In this case, the design layer 12 may be formed by stacking a plurality of print layers formed by 2D printing (see, for example, FIG. 12) or may be formed by a 3D printer (see, for example, FIG. 13). In any case, coloring may be applied on only the surface layer of the design layer 12, or coloring may be applied on the entire design layer 12.

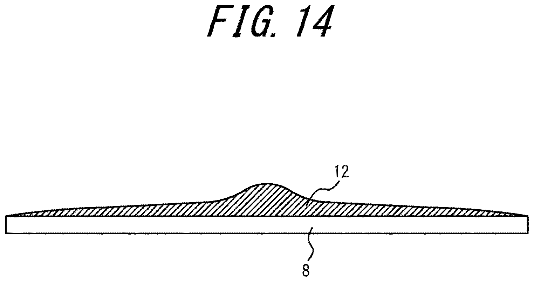

The solar cell module 1 may be configured such that the design region 3 has an uneven thickness (see, for example, FIG. 14).

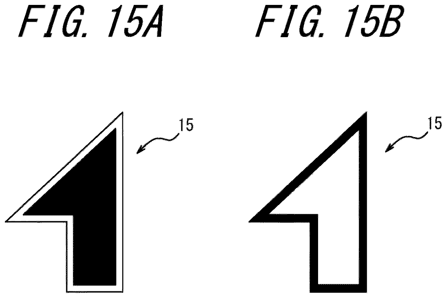

The solar cell module 1 may be configured to have an upper layer region that displays a label 15 (see, for example, FIGS. 15A and 15B) consisting of a character, number, or symbol, on the design region 3.

The solar cell module 1 may be configured such that one of the contour and its inside region of the label 15 is white, and the other is black (see, for example, FIGS. 15A and 15B).

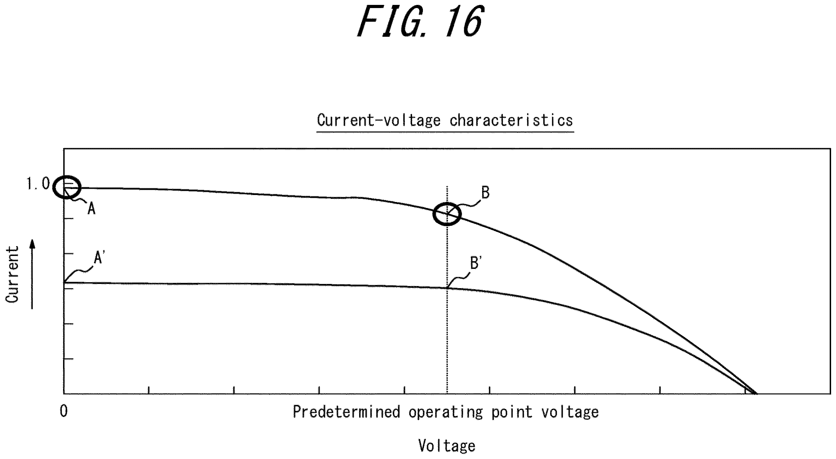

The solar cell module 1 may be configured such that the average transmittance throughout the entire design region 3 in each of the partial regions 5 is (i) a ratio of the short circuit current (see a point A' in FIG. 16) of the solar cell module 1 when the partial region 5 is provided over the entire surface of the power-generating cell 2, with respect to the short circuit current (see a point A in FIG. 16) of the solar cell module 1 without the design region 3, when the power-generating cell 2 is irradiated with sunlight of 1 SUN, or (ii) a ratio of the power generation current at a predetermined operating point voltage (see a point B' in FIG. 16) of the solar cell module 1 when the partial region 5 is provided over the entire surface of the power-generating cell 2, with respect to the power generation current at the predetermined operating point voltage (see a point B in FIG. 16) of the solar cell module 1 without the design region 3, when the power-generating cell 2 is irradiated with sunlight of 1 SUN.

The solar cell module 1 may be configured to have a plurality of power-generating cells 2 and a plurality of design regions 3 corresponding to the plurality of power-generating cells 2 (see, for example, FIG. 1).

The solar cell module 1 may be configured to have a further design region 16 that does not correspond to a plurality of power-generating cells 2 such that the further design region 16 has an average transmittance smaller than the constant C (see, for example, FIG. 4).

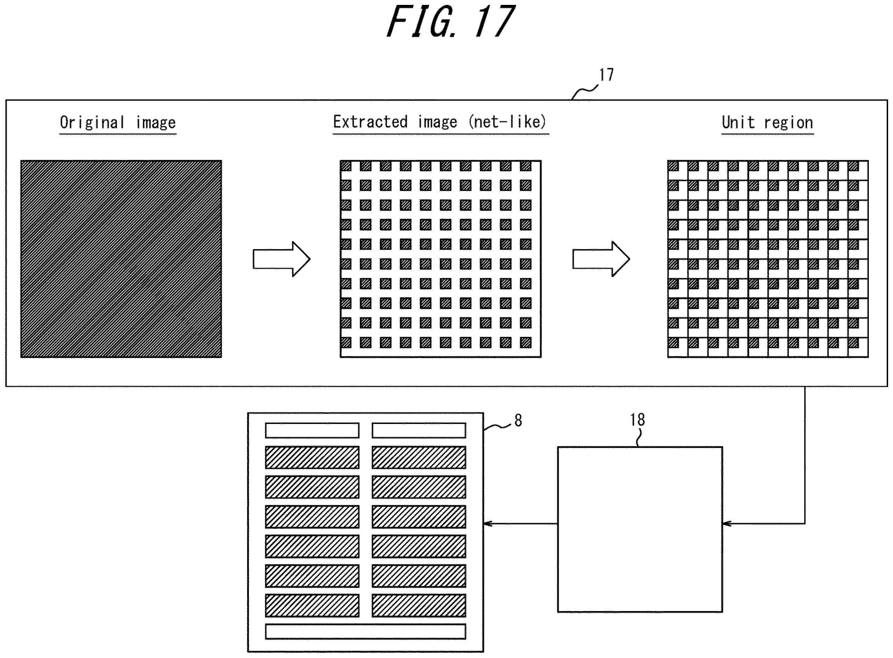

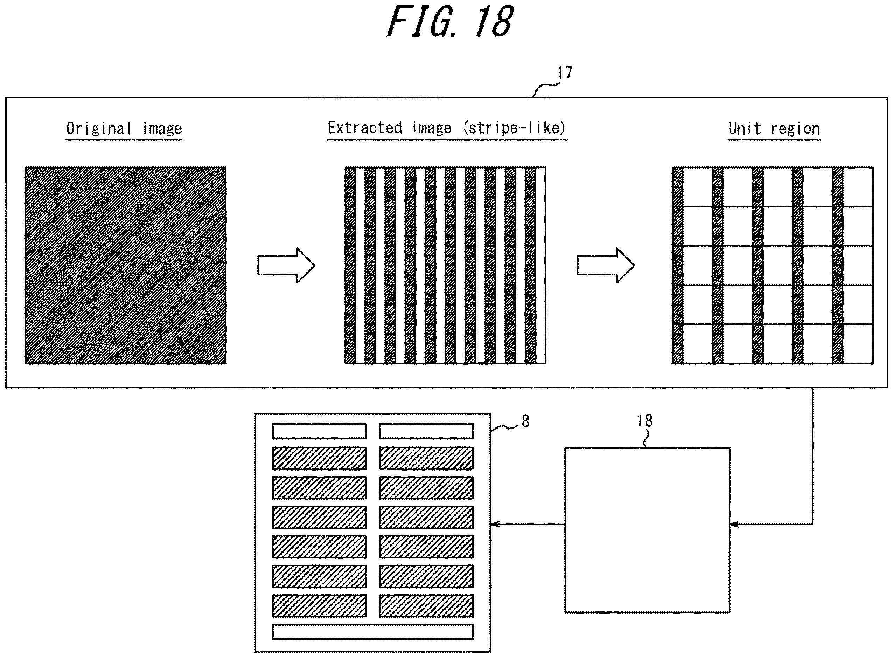

The solar cell module 1 may be produced using a print data generation device 17 (see, for example, FIG. 17 and FIG. 18) that can extract, as print data to be printed on a predetermined region consisting of any of partial regions 5 (for example, the first partial region 5a or the second partial region 5b) of the entire design region 3, a part corresponding to the predetermined region from a predetermined image. That is, the print data generation device 17 may be configured to be able to adjust the average transmittance Td of the design region 3 by setting the form of the unit region 4 as described above. One of the first partial region 5a and the second partial region 5b may be used as a design portion to which a predetermined image is assigned, and the other may be used as a transparent portion having higher transmittance than that of the design portion. One of the first partial region 5a and the second partial region 5b may be used as a design portion to which a predetermined image is assigned, and the other may be used as a background portion to which, for example, a background covered with a solid white color is assigned.

The print data generation device 17 may be configured such that the average transmittance throughout the entire design region 3 and the area fraction in the unit region 4, of each of the partial regions 5 are set so that the average transmittance Td of the design region 3 is not less than the constant C.

The print data generation device 17 may be configured such that the average transmittance Tb of the background region 6, and the average transmittance throughout the entire design region 3 and the area fraction in the unit region 4, of each of the partial regions 5 are set so that a value obtained by multiplying the average transmittance Td of the design region 3 by the average transmittance Tb of the background region 6 is not less than the constant C. In this case, the print data generation device 17 may be configured to be able to edit a predetermined background image, as background print data to be printed on the background region 6, to have the set average transmittance Tb of the background region 6.

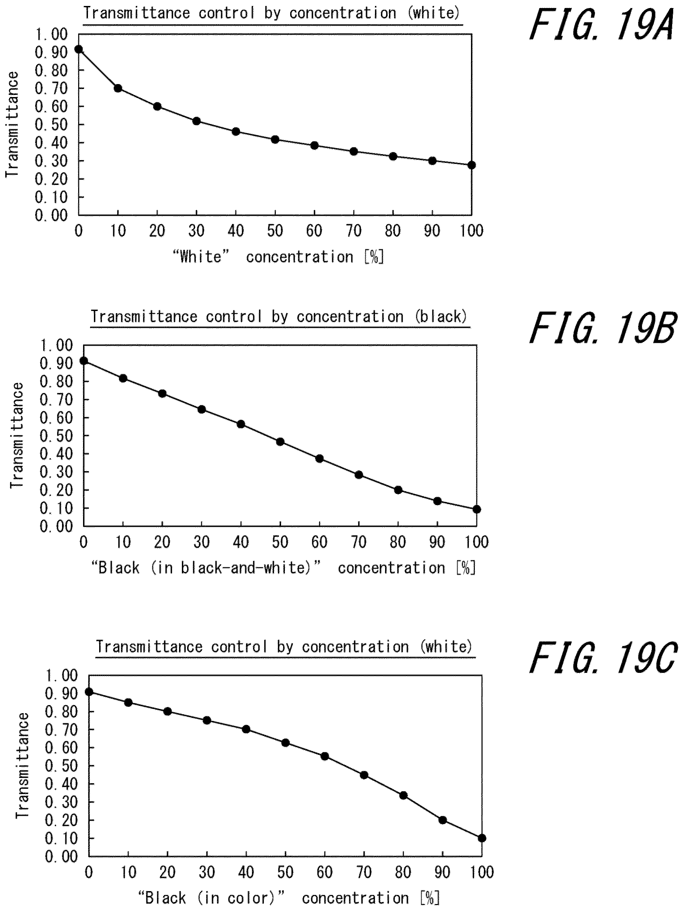

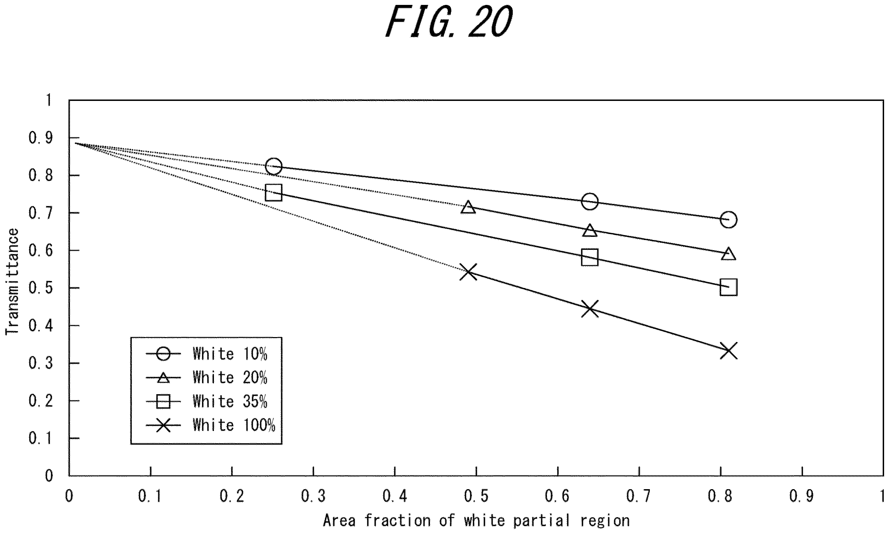

The print data generation device 17 may be configured to be able to adjust the average transmittance Td of the design region 3 not only by (i) the setting of the form of the unit region 4 (second setting means) as described above, but also by (ii) setting the 2D density of the ink on the printed surface (first setting means) as transparency setting in a general image editing application, and/or by (iii) setting the ink concentration (third setting means). A higher ink concentration decreases the transmittance (see FIG. 19A to FIG. 20). This trend is recognized regardless of the color of ink, but the extent differs depending on the color. For example, even in a case of the same black, the extent differs depending on whether it is black in black-and-white print or black in color print (see FIGS. 19A to 19C). FIG. 20 illustrates experimental data when the unit region 4 consists of two partial regions 5 and the first partial region 5a is colored with a solid white color, and there is no coloring on the second partial region 5b. As indicated by this data, a larger area fraction in the unit region 4 of the white first partial region 5a decreases the average transmittance Td of the design region 3.

The solar cell module 1 may be produced using a printer 18 (see, for example, FIG. 17 and FIG. 18) that can apply printing on the solar cell module 1 based on print data generated by the print data generation device 17. The solar cell module 1 may be produced by forming the design layer 12 (and the background layer 11 as necessary) on the transparent film 10 by 2D or 3D printing by the printer 18 and then sticking the transparent film 10 to the solar cell module body 8 via the adhesive layer 9. The solar cell module 1 may be produced by forming the design layer 12 (and the background layer 11 as necessary) directly on the solar cell module body 8 by 2D or 3D printing by the printer 18.

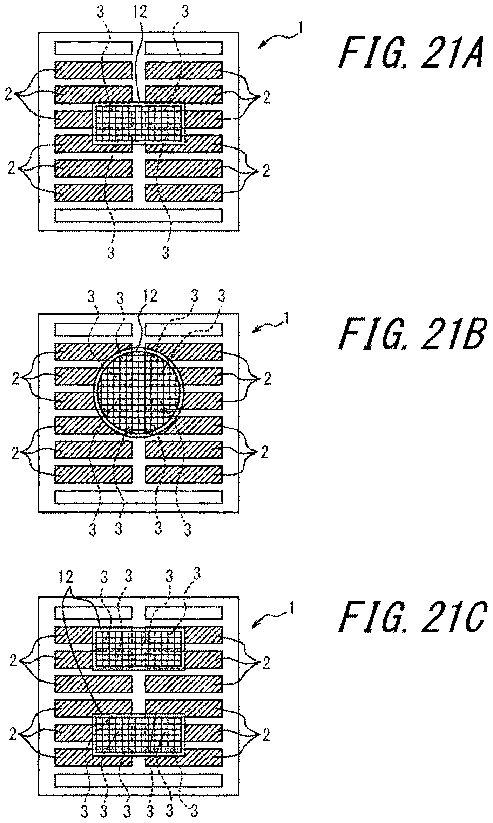

When the solar cell module 1 has a plurality of power-generating cells 2, the solar cell module 1 may be configured such that the design layer 12 is provided corresponding to all of the power-generating cells 2 or may be configured such that the design layer 12 is provided corresponding to a part of the power-generating cells 2 (see, for example, FIGS. 21A to 21C).

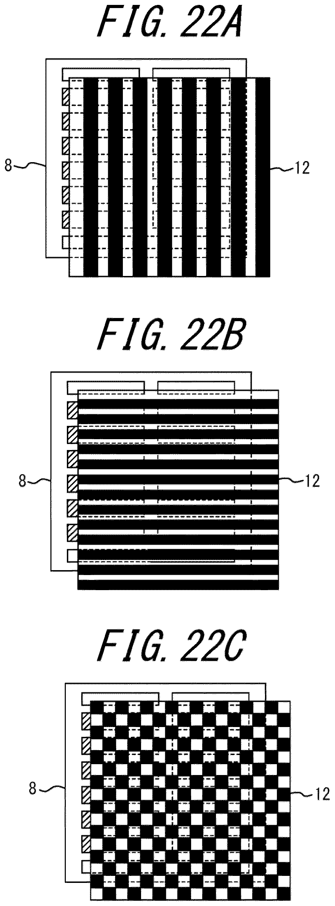

The solar cell module 1 may be configured such that a predetermined image is provided according to a predetermined pattern on only a partial region of the design layer 12. For example, a predetermined image is provided according to a vertical-striped pattern in the example illustrated in FIG. 22A, a predetermined image is provided according to a horizontal-striped pattern in the example illustrated in FIG. 22B, and a predetermined image is provided according to a net-like pattern in the example illustrated in FIG. 22C.

This disclosure is not limited to the aforementioned embodiments and can be variously changed without departing from the gist.

EXAMPLES

(Example 1)

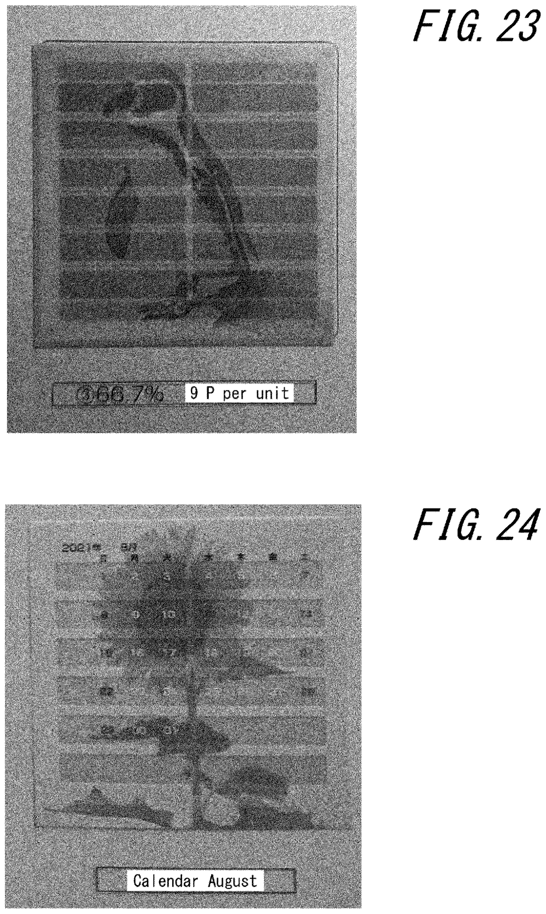

As Example 1, a solar cell module illustrated in FIG. 23 was produced. The unit region had a form illustrated in FIG. 7C, a print data generation device extracted a part corresponding to the first partial region from a penguin image, as print data to be printed on the first partial region, and extracted a part corresponding to the second partial region from a solid white colored image, as print data to be printed on the second partial region. The unit region was a square, and the minimum unit region was a 100-$\mu$m square. The second setting means controlled the transmittance, and the third setting means set the white ink concentration of the second region to 35%. The average transmittance Td as an actual value was measured as (i) a ratio of the short circuit current of the solar cell module when the partial region is provided over the entire surface of the power-generating cell, with respect to the short circuit current of the solar cell module without the design region, when the power-generating cell is irradiated with sunlight of 1 SUN (that is, a ratio of the short circuit current of the solar cell module having a design layer with respect to the short circuit current of the solar cell module without a design layer), and it was 0.61. The current-voltage characteristics (IV characteristics) of the solar cell module were obtained using a solar simulator "PEC-L15" produced by Peccell Technologies, Inc. and a IV characteristics measurement apparatus "PECK2400-N" produced by Peccell Technologies, Inc.

(Example 2)

As Example 2, a solar cell module illustrated in FIG. 24 was produced. The first setting means set the transparency of a sunflower image to be printed on the entire solar cell module including a design region and a further design region to 40%, and printing was performed without using the second setting means (that is, without dividing the design region into a plurality of partial regions). A white background layer was provided, and the third setting means set the concentration of the white to 5% for the design region (power-generating cell part) and to 100% for the further design region (part other than the power-generating cell). The average transmittance Td as an actual value was 0.64. The measurement of the average transmittance was performed as in Example 1.

INDUSTRIAL APPLICABILITY

According to this disclosure, a solar cell module having excellent designability and power generating performance can be provided.

REFERENCE SIGNS LIST

| | |
|---|---|
| 1 | solar cell module |
| 2 | power-generating cell |
| 3 | design region |
| 4 | unit region |
| 5 | partial region |
| 5a | first partial region |
| 5b | second partial region |
| 6 | background region |
| 7 | minimum unit region |
| 8 | solar cell module body |
| 9 | adhesive layer |
| 10 | transparent film |
| 11 | background layer |

12    design layer
13    current-collecting electrode
14    extended region
15    label
16    further design region
17    print data generation device
18    printer

**Claims**

1.  A solar cell module comprising a design region corresponding to a power-generating cell, wherein

    the design region consists of one unit region or a repeat of two or more unit regions,
    the unit region consists of a plurality of partial regions having different average transmittances throughout the entire design region, and
    the average transmittance throughout the entire design region and the area fraction in the unit region, of each of the partial regions are set to satisfy Formula 1 in which the average transmittance of the design region is not less than an arbitrary constant:
    [Math. 1]

    $$T_d = \sum_{m=1}^{n} \left( T_{a\_m} \cdot R_{p\_m} \right) \geq C$$

    $$\dots \text{Formula } 1$$

    wherein Td is an average transmittance of the design region,

    n is the number of partial regions that constitute the unit region,
    Ta_m is an average transmittance throughout the entire design region in the m-th partial region ($0 \leq$ Ta_m $\leq 1$),
    Rp_m is an area fraction in the unit region of the m-th partial region ($0 <$ Rp_m $< 1$), and
    C is an arbitrary constant ($0 \leq$ C $\leq 1$).

2.  The solar cell module according to claim 1, wherein the solar cell module has a background region between the design region and the power-generating cell, and
    the average transmittance of the background region, and the average transmittance throughout the entire design region and the area fraction in the unit region, of each of the partial regions are set to satisfy Formula 2 in which a value obtained by multiplying the average transmittance of the design region by the average transmittance of the background region is not less than the constant:
    [Math. 2]

    $$T_b \cdot \sum_{m=1}^{n} \left( T_{a\_m} \cdot R_{p\_m} \right) \geq C$$

    $$\dots \text{Formula } 2$$

    wherein Tb is an average transmittance of the background region.

3.  The solar cell module according to claim 1 or 2, wherein the constant is set so that the average transmittance of the entire power-generating cell is 0.5 or more.

4.  The solar cell module according to any one of claims 1 to 3, wherein the area fraction of the design region in the power-generating cell is 0.5 or more and 1 or less, and the constant is set to satisfy Formula 3:
    [Math. 3]

$$C = 1 - \frac{1}{2R_d}$$

$$\dots \; \text{Formula 3}$$

wherein Rd is an area fraction of the design region in the power-generating cell ($0.5 \leq Rd \leq 1$).

5. The solar cell module according to claim 2, wherein the background region is white.

6. The solar cell module according to any one of claims 1 to 5, wherein the average transmittance throughout the entire design region in each of the partial regions is adjusted by ink concentration.

7. The solar cell module according to any one of claims 1 to 6, wherein the average transmittance throughout the entire design region in one of the plurality of partial regions is 1.

8. The solar cell module according to any one of claims 1 to 7, wherein the unit region is a square.

9. The solar cell module according to any one of claims 1 to 8, wherein the unit region consists of a plurality of minimum unit regions that are each a square, regular polygon, or circle, and each of the partial regions consists of one or more of the minimum unit regions.

10. The solar cell module according to claim 8, wherein the unit region and the minimum unit region are each a square, and at least one of the partial regions in the unit region is continuously arranged in none of the vertical and horizontal directions along the sides of the square.

11. The solar cell module according to claim 8, wherein the unit region and the minimum unit region are each a square, and at least one of the partial regions in the unit region is continuously arranged in any of the vertical and horizontal directions along the sides of the square.

12. The solar cell module according to any one of claims 1 to 11, wherein the design region is encompassed by a region over the power-generating cell or encompassed by a region including the region over the power-generating cell and an extended region extended by a predetermined width from the end edge of the power-generating cell.

13. The solar cell module according to any one of claims 1 to 12, wherein the design region has an uneven thickness.

14. The solar cell module according to any one of claims 1 to 13, wherein the solar cell module has an upper layer region that displays a label consisting of a character, number, or symbol, on the design region.

15. The solar cell module according to claim 14, wherein one of the contour and its inside region of the label is white, and the other is black.

16. The solar cell module according to any one of claims 1 to 15, wherein the average transmittance throughout the entire design region in each of the partial regions is (i) a ratio of the short circuit current of the solar cell module when the partial regions are provided over the entire surface of the power-generating cell, with respect to the short circuit current of the solar cell module without the design region, when the power-generating cell is irradiated with sunlight of 1 SUN, or (ii) a ratio of the power generation current at a predetermined operating point voltage of the solar cell module when the partial regions are provided over the entire surface of the power-generating cell, with respect to the power generation current at the predetermined operating point voltage of the solar cell module without the design region, when the power-generating cell is irradiated with sunlight of 1 SUN.

17. The solar cell module according to any one of claims 1 to 16, wherein the solar cell module has a plurality of the power-generating cells and a plurality of the design regions corresponding to the plurality of the power-generating cells.

18. The solar cell module according to claim 17, wherein the solar cell module has a further design region that does not correspond to the plurality of the power-generating cells, and
the further design region has an average transmittance smaller than the constant.

19. A print data generation device for the solar cell module according to any one of claims 1 to 16, wherein, as print data to be printed on a predetermined region consisting of any of the partial regions of the entire design region, a part corresponding to the predetermined region is extractable from a predetermined image.

20. The print data generation device according to claim 19, wherein the average transmittance throughout the entire design region and the area fraction in the unit region, of each of the partial regions are set so that the average transmittance of the design region is not less than the constant.

21. A printer configured to apply printing on the solar cell module based on print data generated by the print data generation device according to claim 19 or 20.

# FIG. 1

# FIG. 2

# FIG. 3

# FIG. 4

FIG. 5

FIG. 6A

FIG. 6B

FIG. 6C

FIG. 7A   FIG. 7B   FIG. 7C   FIG. 7D   FIG. 7E

FIG. 8A    FIG. 8B    FIG. 8C    FIG. 8D    FIG. 8E

EP 4 443 742 A1

EP 4 443 742 A1

# FIG. 11A

2, 3

# FIG. 11B

2  3

14

## FIG. 12

## FIG. 13

# FIG. 14

FIG. 15A    FIG. 15B

FIG. 16

Current-voltage characteristics

EP 4 443 742 A1

# FIG. 17

EP 4 443 742 A1

# FIG. 18

Transmittance control by concentration (white)

*FIG. 19A*

Transmittance control by concentration (black)

*FIG. 19B*

Transmittance control by concentration (white)

*FIG. 19C*

# FIG. 20

FIG. 21A

FIG. 21B

FIG. 21C

## FIG. 22A

## FIG. 22B

## FIG. 22C

FIG. 23

FIG. 24

<div align="center">

**INTERNATIONAL SEARCH REPORT**

</div>

| International application No. |
| --- |
| **PCT/JP2022/040924** |

**A.    CLASSIFICATION OF SUBJECT MATTER**

*H02S 40/20*(2014.01)i; *H01L 31/042*(2014.01)i
FI:    H02S40/20; H01L31/04 500

According to International Patent Classification (IPC) or to both national classification and IPC

**B.    FIELDS SEARCHED**

Minimum documentation searched (classification system followed by classification symbols)
    H02S40/20; H01L31/042

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| X | JP 2016-025231 A (DAINIPPON PRINTING CO LTD) 08 February 2016 (2016-02-08) paragraphs [0022]-[0105], fig. 2-5 | 1-4, 7, 12-14, 16-17 |
| Y | | 6, 8-10 |
| A | | 5, 11, 15, 18-21 |
| Y | JP 2019-204064 A (PANASONIC IP MAN CORP) 28 November 2019 (2019-11-28) paragraph [0059] | 6 |
| Y | JP 2001-085721 A (KANEGAFUCHI CHEM IND CO LTD) 30 March 2001 (2001-03-30) paragraphs [0026]-[0027], fig. 3 | 8-10 |
| A | US 2015/0007884 A1 (KALKANOGLU, Husnu M. et al.) 08 January 2015 (2015-01-08) entire text, all drawings | 1-21 |
| A | JP 2017-216766 A (DAINIPPON PRINTING CO LTD) 07 December 2017 (2017-12-07) entire text, all drawings | 1-21 |

☐ Further documents are listed in the continuation of Box C.    ☑ See patent family annex.

| | |
| --- | --- |
| *    Special categories of cited documents:<br>"A"    document defining the general state of the art which is not considered to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
| --- | --- |
| **01 December 2022** | **20 December 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/040924**

| Patent document cited in search report | | | Publication date (day/month/year) | Patent family member(s) | | | Publication date (day/month/year) |
|---|---|---|---|---|---|---|---|
| JP | 2016-025231 | A | 08 February 2016 | (Family: none) | | | |
| JP | 2019-204064 | A | 28 November 2019 | (Family: none) | | | |
| JP | 2001-085721 | A | 30 March 2001 | (Family: none) | | | |
| US | 2015/0007884 | A1 | 08 January 2015 | WO | 2009/089236 | A2 | |
| JP | 2017-216766 | A | 07 December 2017 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017216766 A